# EUROPÄISCHE PATENTSCHRIFT

(11) **EP 1 515 447 B1**
(45) Veröffentlichungstag und Bekanntmachung des Hinweises auf die Patenterteilung: **26.07.2006**
(21) Anmeldenummer: 04021511.3
(22) Anmeldetag: 10.09.2004
(51) Int. Cl.: H04B 1/10, H03G 3/34

(54) **Verfahren zur Unterdrückung von Störungen in einem Signalverarbeitungssystem und Signalverarbeitungssystem**
Method for noise suppression in a signal processing system and signal processing system
Procédé de suppression de bruit dans un système de traitement de signaux et système de traitement de signaux

(30) Priorität: 12.09.2003 DE 10343332
(43) Veröffentlichungstag der Anmeldung: 16.03.2005
(73) Patentinhaber: ATMEL Germany GmbH, 74072 Heilbronn (DE)
(72) Erfinder: Friesen, Leo, 74172 Neckarsulm (DE); Rebel, Reimund, Chandler AZ 85248 (US); Siegel, Martin, 74078 Heilbronn (DE)

(56) Entgegenhaltungen:
- EP-A- 1 271 771
- DE-A- 2 642 755
- US-A- 4 528 678

## Beschreibung

Die Erfindung betrifft in Allgemein ein Verfahren zur Unterdrückung von Störimpulsen in einem amplituden-modulierte Signale verarbeitenden Signalverarbeitungssystem, mit den Schritten: Austasten von Störimpulsen aus einem amplitudenmodulierten Signal, Demodulieren des amplitudenmodulierten Signals nach dem Austasten, und Glätten des nach der Austastung verbleibenden amplituden-modulierten Signals.

Die Erfindung betrifft ferner ein amplitudenmodulierte Signale verarbeitendes Signalverarbeitungssystem mit jeweils wenigstens einem Hochfrequenzabschnitt, einem Zwischenfrequenzabschnitt, einem Demodulationsabschnitt, einem Austastabschnitt und einem Glättungsabschnitt.

Ein solches Verfahren und ein solches Signalverarbeitungssystem sind aus der DE 39 04 505 C2 bekannt.

Allgemein besteht bei amplitudenmodulierte Signale verarbeitenden Signalverarbeitungsanlagen das Problem, dass an der Antenne eintreffende Störimpulse dem eigentlichen Nutzsignal überlagert werden. Das bedeutet, dass die Signalenergie an der Antenne zunimmt. Ein typisches Beispiel sind Störimpulse, die von einer Zündung eines Verbrennungsmotors erzeugt werden und die sich einem amplitudenmodulierten Radiosignal überlagern. Solche Störimpulse treten regelmäßig und mit einer Wiederholungsfrequenz von ca. 60 Hz bis 600 Hz auf. In diesem Frequenzbereich ist das menschliche Ohr sehr empfindlich. Durchläuft der Störimpuls im Empfänger vorhandene Filterstufen, wird zwar das Spektrum und damit auch die Energie der Störung reduziert. Die Zeitdauer der Impulsantwort eines Filters ist aber nach dem Zeit/Bandbreiten-Gesetz mit der Bandbreite des Filters gekoppelt. Daraus ergibt sich, dass eine anfänglich große Amplitude eines Störimpulses durch eine Filterung nur zu Lasten der Impulsbreite im Zeitbereich verringert werden kann, so dass die Impulsbreite mit abnehmender Amplitude anwächst. Dadurch wird sowohl die Detektion des Störimpulses als auch seine Entfernung vom Nutzsignal erschwert.

Die oben genannte DE 39 04 505 C2 stellt einen Vertreter von Systemen dar, bei denen die Detektion der Störung auf der Breitband-Hochfrequenzseite des Systems erfolgt, weil der Impuls dort eine hohe Amplitude aufweist. Bei den bekannten Systemen wird versucht, die Störung schon vor dem Demodulator auf einer Zwischenfrequenz auszutasten. Dort ist die Bandbreite noch groß, was eine Austastzeit im Bereich weniger Mikrosekunden ermöglicht. Dabei wird hier und im Folgenden unter einem Austasten eine kurzzeitige Unterbrechung oder Abschaltung des Signals verstanden. Physikalisch bedeutet eine solche Austastung, dass der unter Umständen große und jedenfalls undefinierte Störimpuls durch eine kleine, definierte Störung, die Austastlücke, ersetzt wird. Diese Störung durchläuft ein üblicherweise vorhandenes Selektionsfilter, das bei Signalverarbeitungssystemen zur Verarbeitung amplitudenmodulierter Signale beispielsweise eine Bandbreite von ca. 3,4 kHz besitzt.

Nach dem Demodulator ist die Zeitdauer der Störung dann auf einige Hundert Mikrosekunden gewachsen. Hier wird nun das Signal erneut ausgetastet. Die dadurch entstehende Lücke (in der Regel ca. 500 Mikrosekunden) versucht man durch mehr oder weniger komplizierte Interpolations-verfahren wieder aufzufüllen. In den seltensten Fällen gelingt das unhörbar. Bei der DE 39 04 505 C2 ist ein Abtast- und Halte-Schaltkreis im Signalpfad hinter dem Demodulator vorgesehen, der die Spannung im Signalpfad während einer Austastung konstant halten soll, um eine Glättung des unterbrochenen Teils eines Audiosignals zu bewirken. Nach der DE 39 04 505 C2 sollen mit dem dort beschriebenen Verfahren Austastzeiten erzielbar sein, die kürzer als 250 Mikrosekunden sind.

Darüber hinaus, beschreibt das Dokument US 4528678 ein Signalverarbeitungssystem, das Mittel zum erkennen eines Störimpuls aufweist, nach Maßgabe derer während einer bestimmen Zeit ein Ersatzsignal an Stelle des Störimpulses in das zu verarbeitende Signal eingefügt wird.

Vor diesem Hintergrund besteht die Aufgabe der Erfindung in der Angabe eines Verfahren zur Unterdrückung von Störungen in einem Signalverarbeitungssystem und in der Angabe eines entsprechenden Signalverarbeitungssystems mit weiter verbesserter Qualität der Störungsunterdrückung.

Diese Aufgabe wird durch die in den Ansprüchen 1 und 7 beschriebene Erfindung gelöst. Vorteilhafte Weiterbildungen der Erfindung sind in den Unteransprüchen beschrieben.

In dem hier vorgestellten Ansatz erfolgt die Signalbearbeitung vor der Demodulation. Als Folge wird vermieden, das sich die Impulsbreite der primären Störung und/oder die Impulsbreite einer sekundären Störung, die durch eine vor dem Demodulator erfolgende Austastung erzeugt wird, durch den Demodulationsprozess und das Durchlaufen eines vorgeschalteten Selektionsfilters verbreitert. In der Summe gelingt es dadurch sowohl die Amplitude als auch die Zeitdauer der hinter dem Demodulator noch vorhandenen Störung signifikant zu verringern. Insbesondere die Verringerung der Zeitdauer hat eine erwünschte Verringerung der Wahrnehmbarkeit der Störung zur Folge.

Es ist bevorzugt, dass das Verfahren folgende weitere Schritte umfasst: Einleiten eines amplituden-modulierten Signals in einen Hochfrequenzabschnitt, oder Einleiten eines amplituden-modulierten Signals in einen Hochfrequenzabschnitt und Verlagern der Frequenz des amplitudenmodulierten Signals auf eine Zwischenfrequenz, wobei das Austasten vor oder nach einem gegebenenfalls erfolgenden Verlagern der Frequenz durchgeführt wird.

Durch diese Merkmale erfolgt das Austasten auch bei Systemen mit Hochfrequenzabschnitten sowie bei Systemen mit Hochfrequenzabschnitten und Zwischenfrequenzabschnitten dort, wo Störimpulse noch eine große Amplitude besitzen und noch nicht verbreitert wurden. Als Folge lassen sich die Störimpulse zuverlässig detektieren und die Austastzeiten gering halten.

Ferner ist bevorzugt, dass der Schritt des Glättens einen Schritt des Einfügen eines Ersatzsignals in das nach der Austastung verbleibende amplitudenmodulierte Signal umfasst.

Durch dieses Merkmal wird auch die gegenüber dem undefiniert großen Störimpuls definiert kleine Störung, die durch das Unterbrechen oder Austasten des Störimpulses erzeugt wird, weiter verringert. Als Folge ergibt sich eine erwünschte Glättung des Signals noch vor der Weiterverarbeitung im Demodulator, bzw. im Demodulationsschritt des Verfahrens..

Bevorzugt ist auch, dass der Schritt des Einfügens eines Ersatzsignals einen Schritt der Bildung eines Ersatzsignals umfasst, das die gleiche Amplitude besitzt wie das amplitudenmodulierte Signal unmittelbar vor dem Störimpuls (1. Forderung). Weiter soll das Ersatzsignal eine Frequenz besitzen, die der Frequenz des amplitudenmodulierten Signals nach der Frequenzverlagerung entspricht (2. Forderung) und das Ersatzsignal soll an den Rändern einer Austastlücke die gleiche Phasenlage besitzen wie das nach der Austastung verbleibende amplitudenmodulierte Signal (3. Forderung).

Durch diese Merkmale wird eine weitgehend perfekte Glättung des nach der Austastung verbleibenden Restsignals durch eine weitgehende Anpassung des Ersatzsignals an das Restsignal erzeugt.

Eine weitere bevorzugte Ausgestaltung sieht vor, dass der Schritt des Austastens nach dem Schritt des Verlagerns der Frequenz auf eine Frequenzbandbreite erfolgt, bei der ein Störimpuls im Zeitbereich eine Impulsbreite von 5 bis 25 Mikrosekunden, insbesondere von 10 bis 20 Mikrosekunden besitzt.

Es hat sich gezeigt, dass Bandbreiten im Frequenzbereich, die durch solche Bedingungen definiert sind, einen guten Kompromiss zwischen den an sich gegensätzlichen Forderungen nach einer möglichst kurzen Zeitspanne für die Signalbehandlung auf der einen Seite und einer möglichst guten Nachbarkanalunterdrückung auf der anderen Seite darstellen.

Mit Blick auf Ausgestaltungen des Signalverarbeitungssystems ist bevorzugt, dass der Glättungsabschnitt ein Glättungsmittel aufweist, das ein Ersatzsignal bildet, das die gleiche Amplitude besitzt wie das amplitudenmodulierte Signal vor dem Störimpuls, dessen Frequenz der Frequenz des amplitudenmodulierten Signals entspricht, und das an den Rändern einer Austastlücke die gleiche Phasenlage besitzt wie das nach der Austastung verbleibende amplitudenmodulierte Signal.

Auch hier gilt, dass durch diese Merkmale eine weitgehend perfekte Glättung des nach der Austastung verbleibenden Restsignals durch eine weitgehende Anpassung des Ersatzsignals an das Restsignal erzielt wird.

Bevorzugt ist auch, dass das Signalverarbeitungssystem jeweils wenigstens einen Hochfrequenzabschnitt, oder einen Hochfrequenzabschnitt und einen Zwischenfrequenz-abschnitt aufweist, die in Laufrichtung der Signale vor dem Austastabschnitt angeordnet sind.

Durch das Anordnen der genannten Abschnitte in Laufrichtung der Signale vor dem Austastabschnitt erfolgt das Austasten dort, wo Störimpulse noch eine große Amplitude besitzen und noch nicht verbreitert wurden. Als Folge lassen sich die Störimpulse zuverlässig detektieren und die Austastzeiten gering halten.

Bevorzugt ist auch, dass der Glättungsabschnitt einen Schwingkreis mit einer Bandbreite aufweist, die kleiner ist als eine Frequenzkanal-Bandbreite der Signalfolge.

Auch hier gilt, dass diese Dimensionierung einen guten Kompromiss zwischen Forderungen nach einer Minimierung der Austastzeit und einer möglichst guten Nachbarkanalunterdrückung darstellt. Mit dem Schwingkreis, der bei ungestörtem Signalverlauf durch das Nutzsignal angeregt wird, lässt sich im Übrigen eine gute Anpassung des Signals im Austastbereich an den Signalverlauf vor und hinter dem Austastbereich erzielen.

Ferner ist bevorzugt, dass der Austastabschnitt einen Entkoppler aufweist, der von einem Störimpulsdetektor gesteuert wird und der einen Eingang des Schwingkreises beim Auftreten eines Störimpulses vom Signalverarbeitungssystem entkoppelt.

Dadurch, dass der Eingang des Schwingkreises (vor dem Eintreffen des Störimpulses) vom Signalverarbeitungssystem entkoppelt wird, schwingt er mit einem Schwingungsverhalten nach, das durch das vor dem Entkoppeln übertragene Nutzsignal geprägt ist. Dadurch stellt der Schwingkreis ein sehr gut zum vorhergehenden Nutzsignalverlauf passendes Ersatzsignal für die nachfolgende Demodulation bereit.

Eine weitere bevorzugte Ausgestaltung zeichnet sich durch eine elektronische Schaltung aus (analog oder digital), die den Schwingkreis beim Entkoppeln vom Signalverarbeitungssystem entdämpft.

Durch dieses Merkmal kann der Schwingkreis im ungestörten Betrieb gedämpft werden, so dass er das Nutzsignal nicht oder nur in einem Ausmaß beeinflusst, das vernachlässigbar ist. Gleichzeitig verhindert die schaltbare Entdämpfung eine zu starke Dämpfung des Schwingkreises nach dem Entkoppeln des Eingangs des Schwingkreises von dem Signalpfad, die das Ersatzsignal unerwünscht beeinflussen würde. Dadurch wird eine gute Glättung des während der Austastung an nachfolgende Stufen weitergegebenen Signals erzielt.

Bevorzugt ist ferner, dass der Schwingkreis eine Parallelschaltung wenigstens einer Induktivität und einer Kapazität aufweist.

Es hat sich gezeigt, dass sich die geforderten Eigenschaften mit einem solchen Parallelschwingkreis besonders gut und ohne großen Schaltungsaufwand erfüllen lassen.

Bevorzugt ist auch, dass die elektronische Schaltung, die den Schwingkreis beim Entkoppeln vom Signalverarbeitungssystem entdämpft, so dimensioniert ist, dass sie die Verluste am Schwingkreis kompensiert.

Vorteile dieser Ausgestaltung liegen darin, dass, bei einer Entkopplung des Schwingkreises von seinem Erreger und gleichzeitiger Kompensation der Verluste, der Kreis mit seiner Eigenfrequenz (vergleiche 1. Forderung) und einer Amplitude entsprechend der gespeicherten Energie (vergleiche 2. Forderung) antworten wird. Die Amplitude bleibt konstant da jegliche Verluste kompensiert werden. Die 3. Forderung (Phasensynchronität) wird dadurch erfüllt, dass am Kreis keine Phasensprünge auftreten können.

Ferner ist bevorzugt, dass die elektronische Schaltung einen negativen Widerstand aufweist.

Durch diese Ausgestaltung wird eine schaltungstechnisch besonders einfach zu erzielende schaltbare Entdämpfung erzielt.

Weitere Vorteile ergeben sich aus der Beschreibung und den beigefügten Figuren.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

### Zeichnungen

Ausführungsbeispiele der Erfindung sind in den Zeichnungen dargestellt und werden in der nachfolgenden Beschreibung näher erläutert. Dabei verweisen gleiche Bezugszeichen jeweils auf gleiche Elemente. Es zeigen:
- Fig. 1: schematisch ein Signalverarbeitungssystem mit einer Störungsunterdrückung nach dem Stand der Technik;
- Fig. 2: schematisch ein Ausführungsbeispiel eines erfindungsgemäßen Signalverarbeitungssystems;
- Fig. 3: qualitative Signalverläufe an verschiedenen Punkten des Signalverarbeitungssystems nach der Fig. 1 und eines erfindungsgemäßen Signalverarbeitungssystems, und
- Fig. 4: einen Teilabschnitt eines weiteren Ausführungsbeispiels eines erfindungsgemäßen Signalverarbeitungssystems.

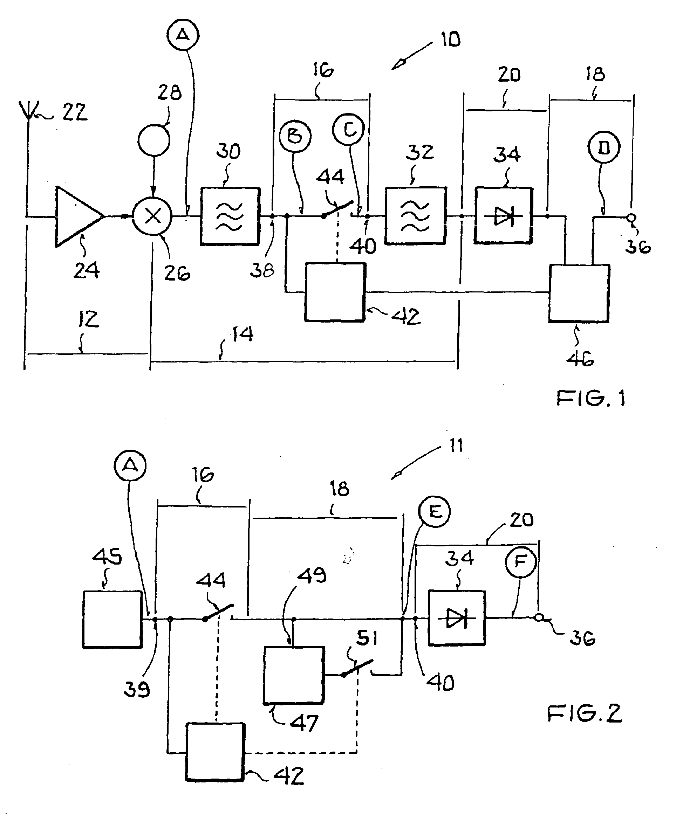

Figur 1 zeigt die Gesamtheit eines bekannten Signalverarbeitungssystems 10 mit einem Hochfrequenzabschnitt 12, einem Zwischenfrequenzabschnitt 14, einem Austastabschnitt 16, einem Glättungsabschnitt 18 und einem Demodulationsabschnitt 20. So wie das Signalverarbeitungssystem in der Fig. 1 dargestellt ist, ist es aus der eingangs genannten DE 39 04 505 C2 bekannt. Der Hochfrequenzabschnitt 12 weist eine Antenne 22 auf, über die amplitudenmodulierte Hochfrequenzsignale oder Radiofrequenzsignale in das Signalverarbeitungssystem 10 eingespeist werden. Die eingespeisten Signale werden durch einen rauscharmen Verstärker 24 verstärkt, bevor sie in einem Mischer 26 durch Mischen mit einem Signal eines Überlagerungsoszillators 28 auf eine Zwischenfrequenz heruntergemischt oder verlagert werden. Der mit dem Ausgang des Mischers 26 beginnende Zwischenfrequenzabschnitt 14 weist einen Zwischenfrequenzfilter 30 auf, der beispielsweise als Bandpassfilter mit einer Bandbreite von 200 kHz realisiert sein kann. Ferner weist der Zwischenfrequenzabschnitt 14 ein Kanalfilter 32 auf, das beispielsweise eine Bandbreite von 3,4 kHz haben kann und das zur Selektion der verschiedenen Übertragungskanäle dient. Das Ausgangssignal des Kanalfilters 32 wird in einem Demodulator 34 demoduliert und das demodulierte Signal wird an einen Anschlusspunkt 36 übergeben, der über weitere Verstärkerstufen beispielsweise mit einem Lautsprecher gekoppelt werden kann.

Zum Unterdrücken von Störungen weist das Signalverarbeitungssystem 10 nach der Figur 1 einen Austastabschnitt 16 und einen Glättungsabschnitt 18 auf. Der Austastabschnitt 16 ist bei dem bekannten System nach der Figur 1 im Zwischenfrequenzabschnitt 14 zwischen einem ersten Knoten 38 und einem zweiten Knoten 40 im Signalverarbeitungspfad angeordnet. Der Glättungsabschnitt 18 ist dagegen bei dem bekannten Signalverarbeitungssystem 10 nach der Figur 1 hinter dem Demodulationsabschnitt 20 angeordnet. Der Austastabschnitt 16 weist einen Störungsdetektor 42 und einen Entkoppler 44 auf, mit dem der Teil des Signalverarbeitungssystems 10, der hinter dem Knoten 40 liegt, vom davor liegenden Teil des Signalverarbeitungssystems 10 entkoppelt werden kann, wenn Störungen in Form von Impulsen auftreten.

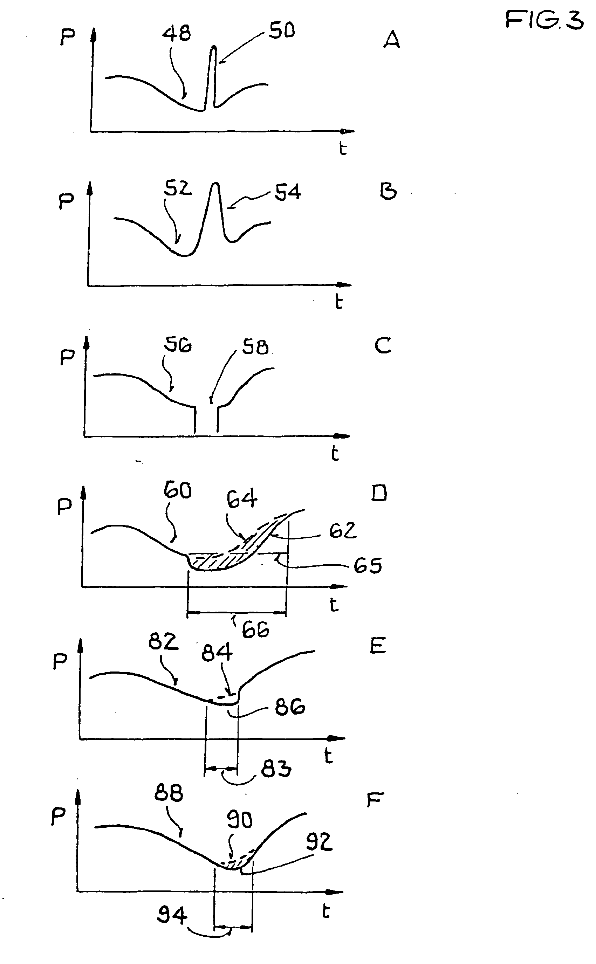

Zur Detektion der Störungen überwacht der Störungsdetektor 42 das Signal. In der Darstellung der Figur 1 bekommt der Störungsdetektor das Signal auf der Zwischenfrequenzebene zugeführt. Beim Auftreten eines für Störimpulse charakteristischen Verlaufes des Signals spricht der Störungsdetektor 42 an und betätigt den Entkoppler 44, der die Weiterleitung des gestörten Signals vom Knoten 38 an den Knoten 40 unterbricht. Um die Auswirkung der Unterbrechung auf das letztlich an den Anschlusspunkt 36 übergebene Signal zu minimieren, sieht der bekannte Gegenstand der Figur 1 eine Abtast-Halteschaltung 46 vor, die vom Störungsdetektor 42 gesteuert wird und hinter dem Demodulator 34 angeordnet ist. Die Auswirkung der Austastung im Austastabschnitt 16 und der Abtast-Halteschaltung 46 im Glättungsabschnitt 18 wird weiter unten unter Bezug auf die Figur 3 dargestellt.

Zunächst wird jedoch unter Bezug auf die Fig. 2 ein Ausführungsbeispiel eines erfindungsgemäßen Signalverarbeitungssystems 11 erläutert. Eine Signalquelle 45 speist ein gestörtes Signal in einen hinter einem Knoten 39 liegenden Teil des Signalverarbeitungssystems 11 ein. Dabei handelt es sich um ein beliebiges amplitudenmoduliertes Signal auf der Zwischenfrequenzebene oder der Hochfrequenzebene. Die Signalquelle 45 repräsentiert damit zum Beispiel einen beliebigen Punkt zwischen der Antenne 22 und dem Störungsdetektor 42 aus der Fig. 1. Das Signal wird im Detektor 42 auf impulsförmige Störungen überprüft. Beim Auftreten von Störimpulsen betätigt der Detektor 42 den Entkoppler 44 und trennt damit die gestörte Signalquelle 45 vom eigentlichen Signalverarbeitungssystem ab. Zeitgleich wird ein Schalter 51 geschlossen, über den ein Glättungsmittel 47 ein geglättetes Signal vor dem Demodulator 34 in das Signalverarbeitungssystem 11 einspeist. Der Demodulator 34 kann beispielsweise schaltungstechnisch als Spitzenwertgleichrichter realisiert sein. Das Glättungsmittel 47 ist bevorzugt als elektronische Schaltung mit Speichermitteln realisiert, die bei geschlossenem Entkoppler 44 mit dem Signal der Signalquelle 45 versorgt wird und daher beim Öffnen des Entkopplers 44 einen vorhergehenden ungestörten Signalzustand speichern kann. In dem vom Block 45 ausgegebenen geglätteten Signal wird damit die Vorgeschichte des Signals aus der Signalquelle 45 vor dem Auftreten der Störung berücksichtigt.

Ein wesentlicher Element der Erfindung in ihrer elementarsten Form besteht darin, dass die Glättung des Signals beim Auftreten einer Störung vor dem Demodulator 34 erfolgt oder durchgeführt wird. Der Gegenstand der Fig. 2 offenbart damit ein Ausführungsbeispiel eines erfindungsgemäßen Signalbearbeitungssystems 11, wenn die einzelnen Elemente als strukturelle Merkmale einer Schaltung betrachtet werden.

Gleichzeitig offenbart die Fig. 2 aber auch ein Ausführungsbeispiel eines erfindungsgemäßen Verfahrens, da die einzelnen Verfahrensschritte einzelnen Blöcken oder Abschnitten des Gegenstandes der Fig. 2 zugeordnet werden können. Die einzelnen Blöcke der Fig. 2 sind daher auch als Funktionsblöcke zu verstehen, die einzelne Verfahrenschritte repräsentieren. Auch bei dieser Lesart ist es wesentlich, dass der Schritt des Glättens, der durch die Funktion des Blockes 45 repräsentiert wird, vor dem Demodulieren erfolgt, das in dem Block 34 durchgeführt wird.

Die Reihenfolge der Blöcke in der Fig. 2 wird daher auch als Abbild einer zeitlichen Reihenfolge der Signalverarbeitung in einem erfindungsgemäßen Verfahren betrachtet, in dem die einzelnen Blöcke Verfahrensschritte repräsentieren. Die einzelnen Blöcke können insbesondere auch als zeitlich hintereinander erfolgende digitale Signalbearbeitungsschritte in einer digitalen Signalverarbeitung realisiert werden. Block 45 ist, unabhängig von einer analogschaltungstechnischen oder digitalen Realisierung, bevorzugt so ausgestaltet, dass sein Ausgangssignal die oben genannten drei Forderungen erfüllt.

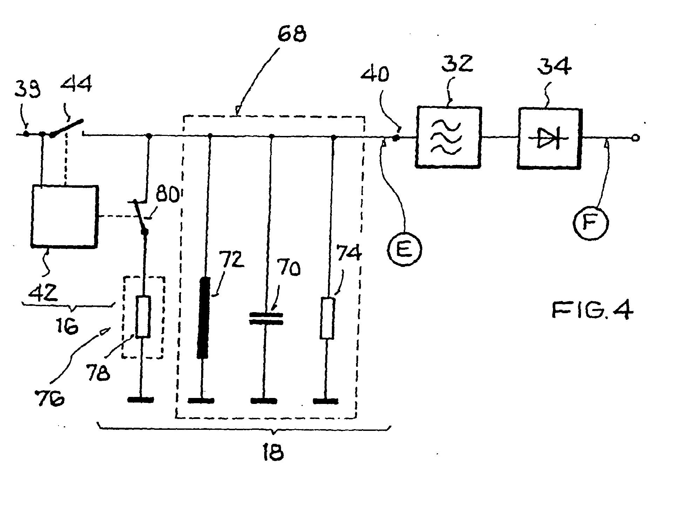

In der Figur 3 sind Verläufe der Leistung dargestellt, wie sie an vier verschiedenen Punkten A, B, C und D in dem bekannten Signalverarbeitungssystem 10 nach der Figur 1 abnehmbar sind. Zusätzlich offenbart die Fig. 3 noch Verläufe von Signalen, wie sie an Punkten E und F von Ausführungsbeispielen der Erfindung in Form von Signalverarbeitungssystemen 11 nach den Figuren 2 und 4 auftreten. Die Punkte A, B, C und D sind in der Figur 1 mit entsprechenden Großbuchstaben eingezeichnet. Entsprechend sind in den Figuren 2 und 4 zumindest die Punkte E und F durch Großbuchstaben gekennzeichnet.

Die Kurve 48 in der Figur 3A zeigt den Verlauf der Leistung in dem Zwischenfrequenzabschnitt 14 hinter dem Mischer 26 beim Auftreten eines Störimpulses 50. Wie aus der Figur 3A ersichtlich ist, besitzt der Störimpuls 50 anfänglich noch eine vergleichsweise kleine zeitliche Breite, die zum Beispiel bei durch Zündimpulsen eines Verbrennungsmotors ausgelösten Störungen im Regelfall kleiner als 20 µs ist.

Figur 3B zeigt mit der Kurve 52 das Signal der Kurve 48 aus Figur 3A nach dem Durchlaufen des Zwischenfrequenzfilters 30. Wegen der endlichen Bandbreite des Zwischenfrequenzfilters 30 von beispielsweise 200 kHz und dem Zeit/Bandbreiten-Gesetz, nach dem die Zeitdauer t eines Signals und der von ihm beanspruchte Frequenzbedarf reziprok zueinander sind, verbreitert sich der ursprünglich schmale Störimpuls 50 aus der Figur 3A zu einer deutlich länger andauenden Störung 54 in der Figur 3B.

Figur 3C zeigt mit der Kurve 56 den Signalabschnitt der Kurven 48 und 52 aus den Figuren 3A und 3B nach der Übertragung zum Punkt C in der Figur 1, der hinter dem Entkoppler 44 liegt. Die Ziffer 58 bezeichnet die durch das Öffnen des Entkopplers 44 entstandene Austastlücke im übertragenen Signal. Diese Austastlücke stellt selbst eine zeitlich noch vergleichsweise schmale Störung des Signals dar, die sich aufgrund des Zeit/Bandbreiten-Gesetzes in Verbindung mit der schmalen Bandbreite des nachfolgenden Kanalfilters 32 (beispielsweise 3,4 kHz) stark verbreitert und verschleift.

Das Ergebnis dieses Prozesses ist in der Figur 3D dargestellt, in der die Kurve 60 den Verlauf des Signalabschnittes aus den Figuren 3A, B und C nach der Weiterleitung an den Punkt D in der Figur 1 angibt. Punkt D ist hinter der Abtast-Halteschaltung 46 in der Fig. 1 angeordnet. Dabei gibt der Kurvenverlauf 62 den Signalverlauf ohne Gegenmaßnahmen an, wie er sich durch das Verschleifen der Austastlücke 58 beim Passieren des Kanalfilters 32, der eine schmale Bandbreite besitzt, und beim Passieren des Demodulators 34 einstellt. Im Vergleich dazu stellt der Kurvenabschnitt 64 den Verlauf eines ungestörten Signals dar, wie es ohne das Auftreten eines Störimpulses 50 und damit ohne Auftreten einer Austastlücke 58 auftreten würde.

Der schraffierte Bereich zwischen beiden Kurven verdeutlicht das Ausmaß der Signalverfälschung, wie es durch Austasten des Störimpulses 50 in das Nutzsignal eingeprägt wird. Die Gerade 65 in der Figur 3D entspricht dem eingefrorenen Endwert der Kurve 60 zum Zeitpunkt des Öffnens des Entkopplers 44 in der Figur 1. Dieser konstante Verlauf ergibt sich bei dem Signalverarbeitungssystem 10 nach der Figur 1 dadurch, dass der Störungsdetektor 42 parallel zum Öffnen des Entkopplers 44 auch die Abtast-Halteschaltung 46 auslöst, die dann den Wert des Nutzsignals vor dem Eintreffen der Störung für eine zu erwartende Dauer der Störung einfriert. Eine solche zu erwartende Zeitdauer der Störung ist in der Figur 3D mit dem Pfeil 66 bezeichnet. Wie aus der Figur 3D ersichtlich ist, ist die Zeitspanne 66 so lang, dass sich das Signal 60 beim Ende der Zeitspanne 66 wieder vergleichsweise stark geändert haben kann, so dass eine Unstetigkeit im Signalverlauf am Übergabepunkt 36 auftritt.

In der Figur 4 sind Elemente eines bevorzugten Ausführungsbeispiels eines erfindungsgemäßen Signalverarbeitungssystems 11 dargestellt, mit denen eine wesentliche Verbesserung, das heißt eine Verringerung des Ausmaßes der Signalstörung und der Dauer der Signalstörung erzielt werden kann. Dabei unterscheidet sich der Ansatz nach dem Ausführungsbeispiel der Figur 4 von dem bekannten Signalverarbeitungssystem 10 nach der Figur 1 dadurch, dass die Signalbearbeitung bereits vor der Demodulation erfolgt. Dabei wird unter dem Begriff der Signalbearbeitung ein Ersetzen des ausgetasteten Signals verstanden. Die Signalbearbeitung basiert beim Gegenstand der Figur 4 auf der Wechselwirkung eines Schwingkreises 68 mit dem übrigen Signalverarbeitungssystem 11. Der Schwingkreis 68 ist bevorzugt zwischen dem Knoten 39 und dem Knoten 40 und hinter dem Entkoppler 44 angeordnet. Das Austasten und Glätten von Störungen erfolgt dementsprechend dort, wo Störimpulse noch eine große Amplitude besitzen und noch nicht verbreitert sind.

Der Schwingkreis 68 kann beispielsweise eine Parallelschaltung aus einer Kapazität 70, einer Induktivität 72 und einem Dämpfungswiderstand 74 aufweisen. Über eine elektronische Schaltung 76 kann der Schwingkreis 68 beim Entkoppeln von der Anregung durch das Signal hinter dem Zwischenfrequenzfilter 44 entdämpft werden. Dazu weist die elektronische Schaltung 76 vorzugsweise einen negativen Widerstand 78 auf. Dabei wird unter einem negativen Widerstand jede Art von Schaltung verstanden, die bei fallender Spannung einen steigenden Strom produziert.

Der negative Widerstand 78, der den Schwingkreis 68 entdämpft, wird vorzugsweise dann über einen Schalter 80 mit dem Schwingkreis gekoppelt, wenn der Störungsdetektor 42 den Schwingkreis 68 mit den nachgelagerten Komponenten 32, 34 und 36 von dem Signal des Zwischenfrequenzfilters 30 entkoppelt. Daher wird der Schalter 80 vorzugsweise ebenfalls vom Störungsdetektor 42 gesteuert und zwar synchron mit der Steuerung des Entkopplers 44. Dabei wird der Schalter 80 immer dann geöffnet, wenn der Entkoppler 44 geschlossen wird und immer dann geschlossen, wenn der Entkoppler 44 geöffnet wird.

Der Schwingkreis 68 sollte eine geeignete Bandbreite besitzen. Ist seine Bandbreite zu schmal, würden Störimpulswirkungen unnötig verlängert, wie es in ähnlicher Form im Zusammenhang mit den Figuren 2C und 2D und dem Signalverarbeitungssystem 10 nach der Figur 1 erläutert worden ist. Besitzt der Schwingkreis 68 dagegen eine zu große Bandbreite, könnte eine zu starke Beeinflussung durch Nachbarkanäle auftreten, so dass die oben genannte erste Forderung nicht erfüllt ist, nach der die Schwingung des Schwingkreises 68 die gleiche Amplitude haben soll wie das Zwischenfrequenzsignal unmittelbar vor dem Eintreffen eines Störimpulses 50.

Beim Auftreten eines Störimpulses im Zwischenfrequenzabschnitt 14 spricht der Störungsdetektor 42 nach der Figur 4 an und entkoppelt den Schwingkreis 68 vom Signal, das eingangsseitig am Knoten 38 anliegt. Als Eingangssignal am Knoten 39 kommt jedes amplitudenmodulierte Signal in Frage. Daher kann an den Knoten 39 sowohl ein Hochfrequenzabschnitt 12 plus Mischer 26 und Zwischenfrequenzfilter 30 aus der Fig. 1, als auch eine Signalquelle 45 aus der Fig. 2 vorgeschaltet sein. Im folgenden wird davon ausgegangen, dass dem Knoten 39 die Struktur aus den Elementen 22, 24, 26, 28 und 30 aus der Fig. vorgeschaltet ist.

Beim Ansprechen des Störungsdetektors 42 und beim Öffnen des Entkopplers 44 wird gleichzeitig ein Schalter 80 und damit eine Verbindung des Schwingkreises 68 mit einer Schaltung 76 mit negativem Widerstand 78 geschlossen. Dadurch wird der Schwingkreis 68, der in diesem Fall nicht mehr durch das Signal aus dem Zwischenfrequenzabschnitt angeregt wird, entdämpft. Dabei bleiben die nachfolgenden Stufen, also insbesondere der Kanalfilter 32 und der Demodulator 34 mit dem Schwingkreis 68 gekoppelt. Die Entdämpfung durch die elektronische Schaltung 76 erfolgt bevorzugt gerade so, dass die Dämpfungsverluste im Schwingkreis 68, die durch den Schwingkreiswiderstand 74 hervorgerufen werden, kompensiert werden. In diesem Fall sieht weder das nachfolgende Kanalfilter 32 noch der Demodulator 34 eine Unterbrechung des Signals.

Diese erwünschte Wirkung beruht darauf, dass die eigentliche Nutzinformation in einem Signalverarbeitungssystem zur Übertragung amplitudenmodulierter Signale in der Amplitude des Signals liegt. Die im Schwingkreis 68 gespeicherte Energie ist daher zum Quadrat der Signalspannung am Schwingkreis proportional. Wird der Schwingkreis von seinem Erreger (Signalquelle 47 oder Ausgang des Zwischenfrequenzfilters 30) abgekoppelt und werden gleichzeitig die Verluste durch Zuschalten des negativen Widerstandes 78 kompensiert, wird der Schwingkreis 68 mit seiner Eigenfrequenz und einer Amplitude antworten, die der gespeicherten Energie entspricht. Durch das Antworten mit seiner Eigenfrequenz ist die oben genannte zweite Forderung erfüllt. Durch das Kompensieren der Verluste bleibt die Amplitude konstant, so dass auch die oben genannte erste Forderung erfüllt wird. Die dritte Forderung wird schließlich dadurch erfüllt, dass am Schwingkreis 68 keine Phasensprünge auftreten können.

In der Figur 3E ist das resultierende Signal hinter dem Schwingkreis 68 dargestellt. Dabei entspricht die gezeichnete Kurve 82 der Übertragung des Signals 48 aus der Figur 2A über eine Signalverarbeitungssystem 10, das hinter dem Knoten 38 so beschaffen ist, wie es in der Figur 2 oder der Figur 4 dargestellt ist. Der mit der Ziffer 83 bezeichnete Zeitabschnitt verdeutlicht die Austastlücke, in der der Entkoppler 44 in den Figuren 2 und 4 geöffnet und der Schalter 51 in der Figur 2 oder der Schalter 80 in der Figur 4 geschlossen ist. Der Kurvenabschnitt 84 zeigt den Verlauf des Signals 82, wie er theoretisch ohne Auftreten eines Störimpulses 50 zu erwarten wäre. Der Kurvenabschnitt 86 zeigt dagegen den Verlauf des tatsächlichen Signals an der Stelle E in den Figuren 2 oder 4, wie er bei einer Signalbearbeitung vor dem Demodulator 34 erzielt wird.

Die Figur 3E verdeutlicht damit auch in graphischer Form, wie der Block 45 nach der Fig. 2 oder der Schwingkreis 68 nach der Figur 4 in der Austastlücke, also während des Zeitfensters 83, ein Ersatzsignal 86 bereitstellt, das nur kurzzeitig und nur wenig vom theoretischen Verlauf ohne Störung abweicht. Dadurch, dass die Abweichung des Ersatzsignals 86 vom theoretischen Verlauf 84 ohne Störung bereits so gering ist, tritt auch im nachfolgenden Kanalfilter 32 und im Demodulator 34 keine größere Verzerrung des Signals auf. Dies ist aus der Figur 3F ersichtlich, die mit der Kurve 88 den Verlauf des Signals aus den vorherigen Figuren 3A, 3B und 3E nun im Punkt F hinter dem Demodulator 34 zeigt. Die Zeitdauer der Störung, die in der Figur 3F durch den Pfeil 94 repräsentiert wird, ist wesentlich kleiner als die Zeitdauer 66 der Störung, wie sie aus dem bekannten Gegenstand nach der Figur 1 resultiert. Die verringerte Zeitdauer bildet den Hauptvorteil der Erfindung, weil die Verringerung der Zeitdauer die Wahrnehmbarkeit der Störung wesentlich beeinflusst. Analog ist auch das Ausmaß der Störung, wie es durch die schraffierten Bereiche in Figur 3F und 3D repräsentiert wird, beim Verlauf nach der Figur 3F wesentlich kleiner als beim Verlauf nach der Figur 3D.

## Patentansprüche

1. Verfahren zur Unterdrückung von Störimpulsen (50) in einem amplitudenmodulierte Signale verarbeitenden Signalverarbeitungssystem (11), mit den Schritten:
- Austasten (16) von Störimpulsen (50) aus einem amplitudenmodulierten Signal (48),
- Glätten (18, 47; 68) des nach dem Austasten (16) verbleibenden amplitudenmodulierten Signals (56) und
- Demodulieren (20, 34) des amplitudenmodulierten Signals,
wobei das Glätten (18, 47; 68) vor dem Demodulieren (20, 34) erfolgt, wobei der Schritt des Glättens (18, 47; 68) einen Schritt des Einfügens eines Ersatzsignals (86) in das nach dem Austasten (16) verbleibende amplitudenmodulierte Signal (56) umfasst und wobei der Schritt des Einfügens des Ersatzsignals (86) einen Schritt der Bildung eines Ersatzsignals (86) umfasst, dessen Frequenz der Frequenz des amplitudenmodulierten Signals (48) entspricht.

2. Verfahren nach Anspruch 1, **dadurch gekennzeichnet, dass** der Schritt des Einfügens des Ersatzsignals (86) einen Schritt der Bildung eines Ersatzsignals (86) umfasst, das an den Rändern einer Austastlücke (83) die gleiche Phasenlage besitzt wie das nach der Austastung (16) verbleibende amplitudenmodulierte Signal (56).

3. Verfahren nach Anspruch 1 oder 2, **dadurch gekennzeichnet, dass** der Schritt des Einfügens des Ersatzsignals (86) einen Schritt der Bildung eines Ersatzsignals (86) umfasst, das die gleiche Amplitude besitzt wie das amplitudenmodulierte Signal (48) vor dem Störimpuls (50).

4. Verfahren nach einem der Ansprüche 1 bis 3, **dadurch gekennzeichnet, dass** das amplitudenmodulierte Signal (48) vor dem Austasten (16) in einen Hochfrequenzabschnitt (12) eingeleitet wird.

5. Verfahren nach einem der vorhergehenden Ansprüche, **gekennzeichnet durch** einen Schritt (26, 28) des Verlagerns der Frequenz des amplitudenmodulierten Signals (48) auf eine Zwischenfrequenz.

6. Verfahren nach Anspruch 5, **dadurch gekennzeichnet, dass** der Schritt des Austastens (16) nach einem Schritt (26, 28) des Verlagerns der Frequenz auf eine Frequenzbandbreite erfolgt, bei der ein Störimpuls im Zeitbereich eine Impulsbreite von 5 bis 25 Mikrosekunden, insbesondere von 10 bis 20 Mikrosekunden, besitzt.

7. Amplitudenmodulierte Signale verarbeitendes Signalverarbeitungssystem (11) mit einem Demodulationsabschnitt (20), einem Austastabschnitt (16) und einem Glättungsabschnitt (18), wobei der Glättungsabschnitt (18) in Laufrichtung der im Signalverarbeitungssystem (11) verarbeiteten Signale vor dem Demodulationsabschnitt (20) angeordnet ist und wobei der Glättungsabschnitt (18) ein Glättungsmittel (47; 68) aufweist, das ein Ersatzsignal (86) bildet, dessen Frequenz der Frequenz eines zu verarbeitenden amplitudenmodulierten Signals (48) entspricht.

8. Signalverarbeitungssystem (11) nach Anspruch 7, **dadurch gekennzeichnet, dass** das Ersatzsignal (86) an den Rändern einer Austastlücke (83) die gleiche Phasenlage besitzt wie das nach einem Durchlaufen des Austastabschnitts (16) verbleibende amplitudenmodulierte Signal (56).

9. Signalverarbeitungssystem (11) nach Anspruch 7 oder 8, **dadurch gekennzeichnet, dass** das Ersatzsignal (86) die gleiche Amplitude besitzt wie das amplitudenmodulierte Signal (48) vor dem Störimpuls (50).

10. Signalverarbeitungssystem (11) nach einem der Ansprüche 7 bis 9, **gekennzeichnet durch** jeweils wenigstens einen Hochfrequenzabschnitt (12), oder einen Hochfrequenzabschnitt (12) und einen Zwischenfrequenzabschnitt (14), die in Laufrichtung der Signale vor dem Austastabschnitt (16) angeordnet sind.

11. Signalverarbeitungssystem (11) nach wenigstens einem der Ansprüche 7 bis 10, **dadurch gekennzeichnet, dass** der Glättungsabschnitt (18) einen Schwingkreis (68) aufweist.

12. Signalverarbeitungssystem (11) nach Anspruch 11, **dadurch gekennzeichnet, dass** der Schwingkreis (68) eine Bandbreite aufweist, die kleiner ist als eine Frequenzkanal-Bandbreite der Signalfolge (48).

13. Signalverarbeitungssystem (11) nach wenigstens einem der Ansprüche 7 bis 12, **dadurch gekennzeichnet, dass** der Austastabschnitt (16) einen Entkoppler (44) aufweist, der von einem Störimpulsdetektor (42) gesteuert wird und der einen Eingang des Schwingkreises (68) beim Auftreten eines Störimpulses (50) vom eingangsseitigen Signalverarbeitungssystem (11) entkoppelt.

14. Signalverarbeitungssystem (11) nach Anspruch 13, **gekennzeichnet durch** eine elektronische Schaltung (76), die den Schwingkreis (68) beim Entkoppeln vom Signalverarbeitungssystem (10) entdämpft.

15. Signalverarbeitungssystem (11) nach Anspruch 14, **dadurch gekennzeichnet, dass** der Schwingkreis (68) eine Parallelschaltung wenigstens einer Induktivität (72) und einer Kapazität (70) aufweist.

16. Signalverarbeitungssystem (11) nach Anspruch 14 oder 15, **dadurch gekennzeichnet dass** die elektronische Schaltung (76), die den Schwingkreis (68) beim eingangsseitigen Entkoppeln vom Signalverarbeitungssystem (10) entdämpft, so dimensioniert ist, dass sie Dämpfungsverluste am Schwingkreis (68) kompensiert.

17. Signalverarbeitungssystem (11) nach wenigstens einem der Ansprüche 14 bis 16, **dadurch gekennzeichnet, dass** die elektronische Schaltung (76) einen negativen Widerstand (78) besitzt.

## Claims

1. Method of suppressing interference pulses (50) in a signal processing system (11) processing amplitude-modulated signals, comprising the steps:
- blanking (16) interference pulses (50) from an amplitude-modulated signal (48),
- smoothing (18, 47; 68) the amplitude-modulated signal (56) remaining after the blanking (16) and
- demodulating (20, 34) the amplitude-modulated signal,
wherein the smoothing (18, 47; 68) is carried out prior to the demodulation (20, 34),
wherein the step of smoothing (18, 47; 68) comprises a step of insertion of a substitute signal (86) into the amplitude-modulated signal (56) remaining after the blanking (16) and
wherein the step of insertion of the substitute signal (86) comprises a step of forming a substitute signal (86), the frequency of which corresponds with the frequency of the amplitude-modulated signal (48).

2. Method according to claim 1, **characterised in that** the step of insertion of the substitute signal (86) comprises a step of forming a substitute signal (86) which has at the edges of a blanking interval (83) the same phase position as the amplitude-modulated signal (56) remaining after the blanking.

3. Method according to claim 1 or 2, **characterised in that** the step of insertion of the substitute signal (86) comprises a step of forming a substitute signal (86) having the same amplitude as the amplitude-modulated signal (48) before the interference pulse (50).

4. Method according to one of claims 1 to 3, **characterised in that** the amplitude-modulated signal (48) is introduced into a high-frequency section (12) before the blanking (16).

5. Method according to one of the preceding claims, **characterised by** a step (26, 28) of displacing the frequency of the amplitude-modulated signal (48) to an intermediate frequency.

6. Method according to claim 5, **characterised in that** the step of blanking (16) is carried out after a step (26, 28) of displacing the frequency to a frequency bandwidth in which an interference pulse has a pulse width of 5 to 25 microseconds, particularly 10 to 20 microseconds, in the time range.

7. Signal processing system (11) processing amplitude-modulated signals, comprising a demodulation section (20), a blanking section (16) and a smoothing section (18), wherein the smoothing section (18) is arranged in front of the demodulation section (20) in running direction of the signals processed in the signal processing system (11) and wherein the smoothing section (18) has a smoothing means (47; 68) forming a substitute signal (86), the frequency of which corresponds with the frequency of an amplitude-modulated signal (48) to be processed.

8. Signal processing system (11) according to claim 7, **characterised in that** the substitute signal (86) has at the edges of a blanking interval (83) the same phase position as the amplitude-modulated signal (56) remaining after running through the blanking section (16).

9. Signal processing system (11) according to claim 7 or 8, **characterised in that** the substitute signal (86) has the same amplitude as the amplitude-modulated signal (48) before the interference pulse (50).

10. Signal processing system (11) according to one of claims 7 to 9, **characterised by** at least one high-frequency section (12), or high-frequency section (12) and intermediate frequency section (14), arranged in front of the blanking section (16) in running direction of the signals.

11. Signal processing system (11) according to at least one of claims 7 to 10, **characterised in that** the smoothing section (18) comprises an oscillator circuit (68).

12. Signal processing system (11) according to claim 11, **characterised in that** the oscillator circuit (68) has a bandwidth smaller than a frequency channel bandwidth of the signal train (48).

13. Signal processing system (11) according to at least one of claims 7 to 12, **characterised in that** the blanking section (16) comprises a decoupler (44) which is controlled by an interference pulse detector (42) and which decouples an input of the oscillator circuit (68) from the signal processing system (11) at the input side on occurrence of an interference pulse (50).

14. Signal processing system (11) according to claim 13, **characterised by** an electronic circuit (76) which subjects the oscillator circuit (68) to attenuation equalisation when decoupled from the signal processing system (10).

15. Signal processing system (11) according to claim 14, **characterised in that** the oscillator circuit (68) comprises a parallel connection of at least one inductance (72) and capacitance (70).

16. Signal processing system (11) according to claim 14 or 15, **characterised in that** the electronic circuit (76) subjecting the oscillator circuit (68) to attenuation equalisation in the case of decoupling from the signal processing system (10) at the input side is so dimensioned that it provides compensation for attenuation losses at the oscillator circuit (68).

17. Signal processing system (11) according to at least one of claims 14 to 16, **characterised in that** the electronic circuit (76) has a negative resistance (78).

## Revendications

1. Procédé de suppression d'impulsions perturbatrices (50) dans un système de traitement de signaux (11) traitant des signaux modulés en amplitude, comprenant les étapes suivantes :
. suppression (16) d'impulsions perturbatrices (50) dans un signal (48) modulé en amplitude,
. lissage (18,47;68) du signal (56) modulé en amplitude restant après la suppression (16), et
. démodulation (20,34) du signal modulé en amplitude,
dans lequel le lissage (18,47;68) est effectué avant la démodulation (20,34), l'étape de lissage (18,47;68) comprenant une étape d'insertion d'un signal de substitution (86) dans le signal (56) modulé en amplitude restant après la suppression (16), et l'étape d'insertion du signal de substitution (86) comprenant une étape de formation d'un signal de substitution (86), dont la fréquence correspond à la fréquence du signal (48) modulé en amplitude.

2. Procédé selon la revendication 1, **caractérisé en ce que** l'étape d'insertion du signal de substitution (86) comprend une étape de formation d'un signal de substitution (86) qui, aux extrémités d'un intervalle de suppression (83), présente la même position de phase que le signal (56) modulé en amplitude restant après la suppression (16).

3. Procédé selon la revendication 1 ou 2, **caractérisé en ce que** l'étape d'insertion du signal de substitution (86) comprend une étape de formation d'un signal de substitution (86) dont l'amplitude est identique à celle du signal (48) modulé en amplitude avant l'impulsion perturbatrice (50).

4. Procédé selon l'une quelconque des revendications 1 à 3, **caractérisé en ce que** le signal (48) modulé en amplitude est introduit avant la suppression (16) dans un module de haute fréquence (12).

5. Procédé selon l'une quelconque des revendications précédentes, **caractérisé par** une étape (26,28) de transposition en fréquence du signal (48) modulé en amplitude à une fréquence intermédiaire.

6. Procédé selon la revendication 5, **caractérisé en ce que** l'étape de suppression (16) s'effectue après une étape (26,28) de transposition de la fréquence dans une largeur de bande de fréquences dans laquelle une impulsion perturbatrice présente une durée de largeur d'impulsion de 5 à 25 microsecondes, plus particulièrement de 10 à 20 microsecondes.

7. Système de traitement de signaux (11) traitant des signaux modulés en amplitude, présentant un module de démodulation (20), un module de suppression (16) et un module de lissage (18), le module de lissage (18) étant disposé avant le module de démodulation (20) dans le sens de progression des signaux traités dans le système de traitement de signaux (11), et le module de lissage (18) présentant un moyen de lissage (47;68) qui forme un signal de substitution (86) dont la fréquence correspond à la fréquence d'un signal (48) modulé en amplitude à traiter.

8. Système de traitement de signaux (11) selon la revendication 7, **caractérisé en ce que** le signal de substitution (86) présente aux extrémités d'un intervalle de suppression (83) la même position de phase que le signal (56) modulé en amplitude restant après un passage dans le module de suppression (16).

9. Système de traitement de signaux (11) selon la revendication 7 ou 8, **caractérisé en ce que** le signal de substitution (86) présente la même amplitude que le signal (48) modulé en amplitude (48) avant l'impulsion perturbatrice (50).

10. Système de traitement de signaux (11) selon l'une quelconque des revendications 7 à 9, **caractérisé par** respectivement au moins à chaque fois un module de haute fréquence (12), ou un module de haute fréquence (12) et un module de fréquence intermédiaire (14), disposé avant le module de suppression (16) dans le sens de progression des signaux.

11. Système de traitement de signaux (11) selon au moins l'une des revendications 7 à 10, **caractérisé en ce que** le module de lissage (18) comporte un circuit oscillant (68).

12. Système de traitement de signaux (11) selon la revendication 11, **caractérisé en ce que** le circuit oscillant (68) présente une largeur de bande inférieure à une largeur de bande de canal de fréquences de la suite de signaux (48).

13. Système de traitement de signaux (11) selon au moins l'une des revendications 7 à 12, **caractérisé en ce que** le module de suppression (16) présente un découpleur (44), commandé par un détecteur (42) d'impulsions perturbatrices et qui, lorsque survient une impulsion perturbatrice (50), découple l'entrée du circuit oscillant (68) du système de traitement de signaux (11) situé du côté entrée.

14. Système de traitement de signaux (11) selon la revendication 13, **caractérisé par** un circuit (76) électronique, qui régénère le circuit oscillant (68) lors du découplage du système de traitement de signaux (10).

15. Système de traitement de signaux (11) selon la revendication 14, **caractérisé en ce que** le circuit oscillant (68) présente un montage en parallèle d'au moins une inductance (72) et d'une capacité (70).

16. Système de traitement de signaux (11) selon la revendication 14 ou 15, **caractérisé en ce que** le circuit électronique (76), qui régénère le circuit oscillant (68) lors du découplage, côté entrée, du système de traitement de signaux (10), présente des dimensions telles qu'il compense des pertes d'amortissement dans le circuit oscillant (68).

17. Système de traitement de signaux (11) selon l'une au moins des revendications 14 à 16, **caractérisé en ce que** le circuit électronique (76) comporte une résistance (78) négative.
